# EUROPÄISCHE PATENTSCHRIFT

(11) **EP 2 638 575 B1**
(45) Veröffentlichungstag und Bekanntmachung des Hinweises auf die Patenterteilung: **12.10.2016**
(21) Anmeldenummer: 11776465.4
(22) Anmeldetag: 02.11.2011
(51) Int. Cl.: H01L 33/08, H01L 33/20, H01L 33/24, H01L 33/50, H01L 33/00, H01L 33/42

(54) **OPTOELEKTRONISCHER HALBLEITERCHIP UND VERFAHREN ZU DESSEN HERSTELLUNG**
OPTOELECTRONIC SEMICONDUCTOR CHIP AND METHOD FOR PRODUCING THE SAME
PUCE SEMI-CONDUCTRICE OPTOÉLECTRONIQUE ET SON PROCÉDÉ DE FABRICATION

(30) Priorität: 12.11.2010 DE 102010051286
(43) Veröffentlichungstag der Anmeldung: 18.09.2013
(73) Patentinhaber: OSRAM Opto Semiconductors GmbH, 93055 Regensburg (DE)
(72) Erfinder: SABATHIL, Matthias, 93059 Regensburg (DE); LINKOV, Alexander, 93059 Regensburg (DE); KÖLPER, Christopher, 93049 Regensburg (DE); STRASSBURG, Martin, 93093 Donaustauf (DE); VON MALM, Norwin, 93152 Nittendorf - Thumhausen (DE)
(74) Vertreter: Epping - Hermann - Fischer
(86) Internationale Anmeldenummer: PCT/EP2011/069247
(87) Internationale Veröffentlichungsnummer: WO 2012/062635

(56) Entgegenhaltungen:
- WO-A1-2008/086855
- DE-A1- 19 638 667
- DE-A1-102008 022 542
- US-A1- 2006 192 225
- US-A1- 2007 085 100
- US-A1- 2007 228 931
- US-A1- 2008 284 313
- US-A1- 2009 039 365
- US-A1- 2009 091 258
- US-A1- 2010 133 562
- US-A1- 2010 176 411

## Beschreibung

Die Erfindung betrifft einen optoelektronischen Halbleiterchip aufweisend einen Halbleiterschichtenstapel und eine Konversionsschicht und ein Verfahren zu dessen Herstellung.

In der Druckschrift WO 2008/086855 A1 ist ein Emitter-Konverter-Chip angegeben.

Die Druckschrift US 2010/0133562 A1 betrifft einen LED-Chip mit einer hohen Helligkeit, der mit einer Aufrauhung versehen ist.

Eine LED-Leuchte ähnlich einer Leuchtstoffröhre ist in der Druckschrift US 2010/0176411 A1 angegeben.

Eine LED mit einem Wellenlängenkonversionselement findet sich in der Druckschrift US 2009/0039365 A1.

Es offenbart die Druckschrift US 2007/0085100 A1 einen Halbleiterchip mit einer Lichtauskoppelstruktur.

Eine Halbleiterbauelement mit einem photonischen Kristall, in dem ein Konversionsstoff eingebettet ist, lässt sich der Druckschrift US 2006/0192225 A1 entnehmen.

Aus der Druckschrift DE 10 2008 022 542 A1 ist ein strahlungsemittierendes Bauelement bekannt, wie auch aus der Druckschrift US 2009/0091258 A1.

Eine weißes Licht emittierende LED ist in der Druckschrift US 2007/0228931 A1 beschrieben.

Die Druckschrift DE 196 38 667 A1 ist gerichtet auf ein mischfarbiges Licht abstrahlendes Halbleiterbauelement.

Eine strukturierte Konversionsschicht ist der Druckschrift US 2008/0284313 A1 zu entnehmen.

Halbleiterchips mit darauf angeordneten Konversionsschichten sind gemäß dem Stand der Technik bekannt, wobei bei den herkömmlichen Halbleiterchips meist die Konversionsschicht einen niedrigeren Brechungsindex als die Schichten des Halbleiterschichtenstapels aufweist. Beispielsweise setzt sich die herkömmlicherweise bekannte Konversionsschicht aus einem Matrixmaterial, beispielsweise Silikon oder Harz, und einem darin angeordneten Konversionselement zusammen. Die Konversionsschicht ist beispielsweise als separate Schicht auf den Halbleiterchip aufgebracht oder als Volumenverguss um den Halbleiterchip angeordnet. Alternativ ist es bekannt, keramische Phosphorplättchen mittels beispielsweise eines Silikonklebers auf den Halbleiterchip zu kleben.

Derartige Konversionsschichten können jedoch nachteilig erhöhte Verluste durch gestreutes und konvertiertes Licht aufweisen, welches von einem Gehäuse oder dem Halbleiterchip selbst nicht vollständig reflektiert wird. Des Weiteren ist die thermische Anbindung der Konversionsschicht an den Halbleiterchip über ein Material, wie beispielsweise Harz oder Silikon, nicht optimal, sodass zusätzliche Effizienzverluste auftreten können. Zudem können Effizienzverluste aufgrund von Alterungseffekten auftreten, wie beispielsweise eine Rissbildung des Matrixmaterials.

Es ist Aufgabe der vorliegenden Anmeldung, einen Halbleiterchip anzugeben, bei dem eine Konversionsschicht optisch und thermisch verbessert an den Halbleiterchip gekoppelt ist und der Halbleiterchip gleichzeitig eine Effizienzsteigerung der Strahlungsauskopplung aufweist.

Weiter ist es Aufgabe der vorliegenden Anmeldung, ein Herstellungsverfahren für einen derartigen Halbleiterchip anzugeben.

Diese Aufgaben werden unter anderem durch einen Halbleiterchip mit den Merkmalen des Anspruchs 1 und durch ein Verfahren zum Herstellen eines derartigen Halbleiterchips mit den Merkmalen des Anspruchs 13 gelöst. Vorteilhafte Weiterbildungen des Halbleiterchips und des Verfahrens zu dessen Herstellung sind Gegenstand der abhängigen Ansprüche.

Gemäß der vorliegenden Erfindung weist der optoelektronische Halbleiterchip einen Halbleiterschichtenstapel auf, der eine zur Strahlungserzeugung vorgesehene aktive Schicht und eine Strahlungsaustrittsseite aufweist. Weiter weist der Halbleiterchip eine Konversionsschicht auf, die auf der Strahlungsaustrittsseite des Halbleiterschichtenstapels angeordnet ist und geeignet ist, zumindest einen Teil der von der aktiven Schicht emittierten Strahlung in Strahlung einer anderen Wellenlänge umzuwandeln. Die Strahlungsaustrittsseite des Halbleiterschichtenstapels weist eine erste Nanostrukturierung auf. Die Konversionsschicht ist in der ersten Nanostrukturierung angeordnet. Die erste Nanostrukturierung setzt sich aus einer Mehrzahl von Nanostäben und Vertiefungen zusammen. Die aktive Schicht ist jeweils nur entlang von Seitenflächen und Grundfläche der ersten Nanostrukturierung angeordnet, sodass die aktive Schicht durch separate, einzelne Bereiche und nicht durch eine zusammenhängende Schicht gebildet ist. Ein optoelektronischer Halbleiterchip ist insbesondere ein Halbleiterchip, der die Umwandlung von elektronisch erzeugten Daten oder Energien in Lichtemission ermöglicht oder umgekehrt. Gemäß der vorliegenden Erfindung ist der optoelektronische Halbleiterchip ein strahlungsemittierender Halbleiterchip.

Eine Nanostrukturierung ist insbesondere eine dreidimensionale Struktur, also eine Struktur, die räumlich ausgebildet ist. Beispielsweise ist eine Nanostrukturierung gebildet durch eine Ausnehmung oder einen Graben in einer Schicht oder einer Schichtenfolge. Unter einer Nanostrukturierung ist insbesondere keine bloße Aufrauung der Strahlungsaustrittsseite zu verstehen. Eine Nanostrukturierung im Sinne der Anmeldung muss demnach von einer ebenen Fläche eine größere räumliche Abweichung aufweisen als eine bloße Aufrauung dieser Fläche.

Die Konversionsschicht ist vorliegend in der ersten Nanostrukturierung angeordnet. Das impliziert, dass die Konversionsschicht der Strahlungsaustrittsseite direkt nachgeordnet ist, sodass die von der aktiven Schicht erzeugte emittierte Strahlung beim Austritt aus dem Halbleiterchip durch die Konversionsschicht tritt oder in der Konversionsschicht in Strahlung einer anderen Wellenlänge umgewandelt wird.

Die Strahlungsaustrittsseite des Halbleiterschichtenstapels weist also eine räumliche Struktur auf, wobei aufgrund der Nanostrukturierung ausgebildete Ausnehmungen, Vertiefungen oder Gräben mit der Konversionsschicht zumindest stellenweise gefüllt sind. Vorzugsweise sind die Vertiefungen, Ausnehmungen oder Gräben der ersten Nanostrukturierung vollständig mit Material der Konversionsschicht gefüllt.

Aufgrund der ersten Nanostrukturierung des Halbleiterschichtenstapels wird eine großflächige Berührungsfläche zwischen Konversionsschicht und Halbleiterschichtenstapel erzeugt. Dadurch ermöglicht sich vorteilhafterweise eine große Wechselwirkungsfläche zwischen Konversionsschicht und Halbleiterschichtenstapel, wodurch eine verbesserte optische und thermische Kopplung der Konversionsschicht an den Halbleiterschichtenstapel erzeugt wird. Die Konversionsschicht steht also großflächig mit dem Halbleiterschichtenstapel, insbesondere der Strahlungsaustrittsseite, in direktem Kontakt. Aufgrund dieser großen Oberflächenberührung kann mit Vorteil die Konversionseffizienz erhöht werden. Dabei kann gleichzeitig eine verbesserte Steuerbarkeit der Konversion erzielt werden.

Ein derartiger Halbleiterchip weist vorteilhafterweise eine Reduktion der Streuverluste bei der Konversion, eine bessere Farbhomogenität über den Einfallswinkel der von der aktiven Schicht emittierte Strahlung, eine gute thermische Anbindung der Konversionsschicht an den Halbleiterschichtenstapel sowie die Möglichkeit auf, eine Vollkonversion zu ermöglichen.

Unter Vollkonversion ist insbesondere eine Strahlungskonversion zu verstehen, bei dem nahezu die gesamte von der aktiven Schicht emittierte Strahlung in der Konversionsschicht in Strahlung einer anderen Wellenlänge umgewandelt wird.

Zudem ermöglicht ein derartiger Halbleiterchip mit integrierter Konversionsschicht ein Bauelement, das ohne Volumenverguss oder einem Package ausgebildet ist, um Konversion zu betreiben. Derartige Halbleiterchips können somit direkt auf beispielsweise eine Leiterplatte gelötet werden. Dies führt zu einer Verringerung der Kosten bei gleichzeitig optimaler Strahlungseffizienz. Die thermische und optische Kopplung der Konversionsschicht an den Halbleiterschichtenstapel ist insbesondere von Vorteil für Anwendungen, die eine hohe Leuchtdichte benötigen, wie beispielsweise Projektionsanwendungen, Headlampen und Spotlichtanwendungen.

Der Halbleiterschichtenstapel, insbesondere die aktive Schicht, enthält mindestens ein III/V-Halbleitermaterial, etwa ein Material aus den Materialsystemen InₓGa_{y}Al_{1-x-y}P, InₓGa_{y}Al_{1-x-y}N oder InₓGa_{y}Al_{1-x-y}As, jeweils mit 0 ≤ x, y ≤ 1 und x + y ≤ 1. III/V-Halbleitermaterialien sind zur Strahlungserzeugung im ultravioletten (InₓGa_{y}Al_{1-x-y}N), über den sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y}As) Spektralbereich besonders geeignet.

Die Konversionsschicht ist beispielsweise eine Schicht aufweisend ein Materialmatrix und ein darin eingebettetes Konversionselement, das geeignet ist, zumindest einen Teil der von der aktiven Schicht emittierten Strahlung in Strahlung einer anderen Wellenlänge umzuwandeln. Geeignete Konversionselemente sind dem Fachmann bekannt und werden daher an dieser Stelle nicht näher erörtert. Das Matrixmaterial weist beispielsweise Silikon oder Harz auf. Das Konversionselement ist vorzugsweise gleichmäßig in dem Matrixmaterial eingebracht, sodass eine gleichmäßige Strahlungsauskopplung über den Auskopplungswinkel und eine gleichmäßige Strahlungskonversion ermöglicht wird.

Gemäß der vorliegenden Erfindung ist die erste Nanostrukturierung als eine Mehrzahl von Nanostäben und Vertiefungen ausgebildet. Als Nanostab wird insbesondere eine stab- oder säulenartige Struktur bezeichnet, die eine größere Höhe als laterale Ausdehnung aufweist. Dem Fachmann sind so genannte Nanostäbe beispielsweise auch unter dem Begriff Nanorod oder Nanowire bekannt. Dabei können die Nanostäbe eine runde, ovale oder eckige Querschnittsfläche aufweisen.

Die Nanostäbe weisen dabei vorzugsweise eine gleichmäßige Verteilung auf. Zwischen den einzelnen Nanostäben sind dabei Zwischenbereiche, nämlich Vertiefungen, angeordnet, die vorzugsweise in etwa jeweils gleich groß ausgebildet sind. Die Nanostäbe sind insbesondere in dem Halbleiterschichtenstapel ausgebildet, sodass die Nanostäbe Material des Halbleiterschichtenstapels umfassen. Eine matrixartige Anordnung der Nanostäbe in Aufsicht auf den Halbleiterchip ist von Vorteil.

In einer Weiterbildung füllt die Konversionsschicht die erste Nanostrukturierung derart aus, dass eine ebene Fläche ausgebildet ist. In diesem Fall füllt die Konversionsschicht die Vertiefungen, Zwischenräume, Ausnehmungen oder Gräben der ersten Nanostrukturierung des Halbleiterschichtenstapels vollständig aus, sodass der Halbleiterschichtenstapel in Kombination mit der Konversionsschicht eben ausgebildet ist. Insbesondere gehen die von dem Halbleiterschichtenstapel abgewandte Seite der Konversionsschicht und die Strahlungsaustrittsseite des Halbleiterschichtenstapels nahtlos ineinander über.

In einer Weiterbildung ist die Konversionsschicht als zweite Nanostrukturierung ausgebildet, die eine Mehrzahl von Nanostäben umfasst. Die Nanostäbe der ersten Nanostrukturierung und die Nanostäbe der zweiten Nanostrukturierung sind dabei vorzugsweise in lateraler Richtung nebeneinander angeordnet. Die Nanostäbe der zweiten Nanostrukturierung sind dabei in den Zwischenräumen der Nanostäben der ersten Strukturierung angeordnet. Zwischen der ersten Nanostrukturierung und der zweiten Nanostrukturierung ist vorzugsweise kein Abstand angeordnet, sodass diese direkt aneinandergrenzen.

In einer Weiterbildung sind die erste Nanostrukturierung und die zweite Nanostrukturierung derart zueinander angeordnet, dass diese ineinandergreifen. Sind die erste und die zweite Nanostrukturierung demnach als Nanostäbe ausgebildet, so sind die Nanostäbe der ersten Nanostrukturierung und die Stäbe der zweiten Nanostrukturierung zueinander versetzt, sodass die Nanostäbe der ersten Nanostrukturierung in den Zwischenräumen der Nanostäbe der zweiten Nanostrukturierung angeordnet sind, und umgekehrt.

In einer Weiterbildung sind die erste Nanostrukturierung und die zweite Nanostrukturierung kammartig zueinander ausgebildet. Insbesondere greifen die erste und die zweite Nanostrukturierung kammartig ineinander.

In einer Weiterbildung grenzen die erste Nanostrukturierung und die zweite Nanostrukturierung derart aneinander an, dass diese eine Schichtenfolge aufweisend eine Mehrzahl von ersten Schichten und eine Mehrzahl von zweiten Schichten in lateraler Richtung ausbilden.

In lateraler Richtung bedeutet insbesondere senkrecht zur Hauptabstrahlrichtung des Halbleiterchips. Insbesondere ist der Halbleiterchip vorzugsweise ein oberflächenemittierender Halbleiterchip, dessen Hauptabstrahlrichtung senkrecht zur lateralen Ausdehnung der Schichten des Halbleiterschichtenstapels gerichtet ist. In lateraler Richtung bedeutet also vorliegend senkrecht zur Ausdehnungsebene der Schichten des Halbleiterschichtenstapels. Insbesondere bedeutet in lateraler Richtung senkrecht zu einer Aufwachsrichtung der Schichten des Halbleiterschichtenstapels.

In einer Weiterbildung ist die Konversionsschicht zusätzlich auf der ersten Nanostrukturierung angeordnet. In diesem Fall ist die Konversionsschicht somit nicht nur in den Vertiefungen, Ausnehmungen oder Gräben der ersten Nanostrukturierung angeordnet und füllt diese vollständig aus, sondern überragt diese Vertiefungen der ersten Nanostrukturierung. In diesem Fall kann die Konversionsschicht beispielsweise in zwei unterschiedliche Bereiche eingeteilt werden. Im ersten Bereich ist die Konversionsschicht strukturiert ausgebildet, vorzugsweise als Nanostäbe. Im zweiten Bereich dagegen ist die Konversionsschicht ganzflächig auf den Halbleiterschichtenstapel aufgebracht. Eine Strukturierung im zweiten Bereich liegt somit nicht vor.

In einer Weiterbildung weisen die erste Nanostrukturierung und/oder die zweite Nanostrukturierung jeweils eine Höhe in einem Bereich zwischen einschließlich 100 nm und einschließlich 1 µm auf. Die Höhe der Nanostäbe der ersten und zweiten Nanostrukturierung ist vorzugsweise nahezu identisch. Besonders bevorzugt entspricht die Höhe der ersten Nanostrukturierung der Höhe der zweiten Nanostrukturierung, sodass ein nahtloser Übergang zwischen der Konversionsschicht und dem Halbleiterschichtenstapel ermöglicht wird.

Die Nanostäben weisen dabei eine Höhe in einer Größenordnung einer Eindringtiefe der von der aktiven Schicht emittierten Strahlung in die Konversionsschicht auf. Als Eindringtiefe ist insbesondere die Länge zu verstehen, mit der eine optische Welle in ein anderes insbesondere niedrigbrechenderes Material eindringt, obwohl der Lichtstrahl eigentlich totalreflektiert wird. Die Eindringtiefe ist dabei abhängig vom Einfallswinkel der Strahlung auf die Grenzfläche zwischen Konversionsschicht und Halbleiterschichtenstapel.

Gemäß der vorliegenden Erfindung ist die aktive Schicht des Halbleiterschichtenstapels jeweils nur entlang von Seitenflächen und Grundfläche der ersten Nanostrukturierung angeordnet.

Mit dieser erfindungsgemäßen Anordnung der aktiven Schicht im Bereich der ersten Nanostrukturierung ist die aktive Schicht entlang der einzelnen Nanostrukturen ausgebildet. Da setzt sich die erste Nanostrukturierung aus einer Mehrzahl von Nanostäben und Vertiefungen zusammen, so ist die aktive Schicht jeweils entlang der Seitenflächen und der Grundfläche der Vertiefungen ausgebildet und beispielsweise umgibt diese jeweils einstückig. Beispielsweise ummantelt die aktive Schicht die Nanostäbe. Dabei kann zwischen den Vertiefungen der ersten Nanostrukturierung und der aktiven Schicht zusätzlich Material des Halbleiterschichtenstapels angeordnet sein.

Gemäß der vorliegenden Erfindung ist die aktive Schicht durch separate, einzelne Bereiche und nicht durch eine zusammenhängende Schicht gebildet. Beispielsweise weisen diese separate, einzelne Bereiche näherungsweise die Form einer Mantelfläche eines halben Zylinders oder eines halben Kegelstumpfes auf, halbiert insbesondere senkrecht zu einer Längsachse des Zylinders oder Kegelstumpfes. Es ist möglich, dass die aktive Schicht, im Querschnitt gesehen, ähnlich einem Rechtecksägezahnmuster geformt ist.

In einer Weiterbildung sind die Konversionsschicht und der Halbleiterschichtenstapel optisch und thermisch miteinander gekoppelt. Eine derartige Kopplung wird beispielsweise durch die Materialauswahl des Halbleiterschichtenstapels und der Konversionsschicht ermöglicht. Eine optische Kopplung erfolgt beispielsweise über ähnliche oder gleiche Brechungsindizes der Materialien. Beispielsweise liegt der Brechungsindex des Materials der Konversionsschicht und des Materials des Halbleiterschichtenstapels bei etwa 2,4.

In einer Weiterbildung ist der Halbleiterchip ein Dünnfilmchip. Als Dünnfilmchip wird im Rahmen der Anmeldung ein Halbleiterchip angesehen, während dessen Herstellung das Aufwachssubstrat, auf dem der Halbleiterschichtenstapel epitaktisch aufgewachsen wurde, vorzugsweise vollständig abgelöst ist. Der Dünnfilmchip kann dabei beispielsweise ein Trägersubstrat zur mechanischen Stabilisierung der Halbleiterschichten des Halbleiterschichtenstapels aufweisen.

In einer Weiterbildung ist der strahlungsemittierende Halbleiterchip eine LED, vorzugsweise eine Dünnfilm-LED.

In einer Weiterbildung umfasst die Konversionsschicht ein hoch-brechendes Material. Hierunter ist insbesondere zu verstehen, dass das Material der Konversionsschicht einen Brechungsindex aufweist, der größer ist als der Brechungsindex des Materials des Halbleiterschichtenstapels. Beispielsweise ist der Brechungsindex der Konversionsschicht bei einem Halbleiterschichtenstapel auf GaN-Basis höher als etwa 2,4.

Die zweite Nanostrukturierung kann dabei als vertikale Schichtabfolge, als eingebettete Konversionspartikel in dem hochbrechenden Material oder als eingebettete hochbrechende Konversionspartikel ausgebildet sein.

Im Falle von GaN-Halbleiterchips findet als mögliches hochbrechendes Material beispielsweise TiO₂ Verwendung, das einen Brechungsindex von etwa 2,9 aufweist. Durch ein geeignet gewähltes Volumenverhältnis der Materialien der Konversionsschicht kann so beispielsweise bei einem Brechungsindex der Konversionspartikel von 1,8 ein mittlerer Brechungsindex der Konversionsschicht nahe 2,4 erzielt werden.

Bei Halbleiterchips, die eine strukturierte Konversionsschicht mit hochbrechendem Material und gleichzeitig vorzugsweise Strukturgrößen im Bereich kleiner als die von der aktiven Schicht emittierten Strahlungswellenlänge aufweisen, wird ein Eindringen des von der aktiven Schicht emittierten Lichts in die Konversionsschicht verbessert.

Gemäß der vorliegenden Erfindung weist ein Verfahren zum Herstellen eines derartigen optoelektronischen Halbleiterchips folgende Schritte auf:
- Bereitstellen eines Aufwachssubstrats,
- Aufwachsen eines Halbleiterschichtenstapels auf das Aufwachssubstrat, der eine aktive Schicht und eine Strahlungsaustrittsseite umfasst,
- Ausbilden einer ersten Nanostrukturierung an der Strahlungsaustrittsseite, und
- Einbringen einer Konversionsschicht in die erste Nanostrukturierung.

Die in Verbindung mit dem optoelektronischen Halbleiterchip genannten Merkmale gelten auch für das Verfahren und umgekehrt.

Bei dem Verfahren wird die Konversionsschicht demnach erst nach dem epitaktischen Aufwachsen des

Halbleiterschichtenstapels aufgebracht. Dies ermöglicht eine bessere Steuerbarkeit der Konversion.

Durch Einbringen der Konversionsschicht in die Nanostrukturierung des Halbleiterschichtenstapels entsteht eine vergrößerte Grenzfläche zwischen Konversionsschicht und Halbleiterschichtenstapel, sodass eine größere Wechselwirkungsfläche der Konversionsschicht mit dem Halbleiterschichtenstapel ermöglicht wird. Die erste Nanostrukturierung ist als eine Mehrzahl von Nanostäben und Vertiefungen ausgebildet, in die die Konversionsschicht eingebracht wird.

Dabei kann die Konversionsschicht derart in die erste Nanostrukturierung des Halbleitermaterials eingebracht werden, dass die Höhe der Vertiefungen der ersten Nanostrukturierung gleich der Höhe der Konversionsschicht ist. In diesem Fall füllt die Konversionsschicht die Vertiefungen der ersten Nanostrukturierung vollständig aus und überragt diese jedoch nicht.

Alternativ kann die Konversionsschicht zusätzlich auf der Nanostrukturierung des Halbleiterschichtenstapels angeordnet sein, sodass die Konversionsschicht die Nanostrukturierung des Halbleiterschichtenstapels überragt. Oberhalb der ersten Nanostrukturierung des Halbleiterschichtenstapels ist in diesem Fall die Konversionsschicht ganzflächig aufgebracht.

Nach dem Aufbringen der Konversionsschicht auf den Halbleiterschichtenstapel kann das Aufwachssubstrat von dem Halbleiterschichtenstapel gelöst beziehungsweise vollständig entfernt werden. Die Seite des Halbleiterschichtenstapels, an dem das Aufwachssubstrat angeordnet war, ist insbesondere die der Strahlungsaustrittsseite gegenüberliegende Seite des Halbleiterchips.

In einer Weiterbildung umfassen das Aufwachsen des Halbleiterschichtenstapels und das Ausbilden der ersten Nanostrukturierung die folgenden Schritte:
- Aufwachsen von ersten Schichten des Halbleiterschichtenstapels ganzflächig auf das Aufwachssubstrat, und
- Aufwachsen von strukturierten zweiten Schichten des Halbleiterschichtenstapels mittels einer Maskenschicht.

Die erste Nanostrukturierung des Halbleiterschichtenstapels kann also durch zwei unterschiedliche Verfahren hergestellt werden. Zum einen kann der Halbleiterschichtenstapel ganzflächig auf dem Aufwachssubstrat aufgewachsen und anschließend strukturiert werden. Alternativ kann ein nichtstrukturierter Teil des Halbleiterschichtenstapels ganzflächig aufgewachsen werden und anschließend der strukturierte Bereich des Halbleiterschichtenstapels mittels beispielsweise einer Maskenschicht direkt strukturiert aufgewachsen werden, sodass eine nachträgliche Strukturierung nicht notwendig ist.

In einer Weiterbildung wird in die erste Nanostrukturierung ein Konversionselement der Konversionsschicht eingebracht und anschließend in die erste Nanostrukturierung ein Matrixmaterial der Konversionsschicht hinzugefügt. In die Vertiefungen der ersten Nanostrukturierung wird somit zuerst das Konversionselement beispielsweise Konversionspartikel eingebracht, wobei anschließend diese Konversionspartikel mit dem Matrixmaterial der Konversionsschicht umgossen werden.

Alternativ kann die Konversionsschicht mittels beispielsweise eines Laserstrahlverdampfens aufgebracht werden. In diesem Fall werden das Matrixmaterial und das darin enthaltene Konversionselement zusammen in die Vertiefungen der ersten Nanostrukturierung und auf die ersten Nanostrukturierung aufgebracht. Derartige Verfahren sind dem Fachmann auch unter dem Begriff PLD-Verfahren (PLD: pulsed laser deposition) bekannt.

In einer Weiterbildung des Verfahrens wird die Größe der ersten Nanostrukturierung derart ausgebildet, dass diese etwa im Bereich der Eindringtiefe der von der aktiven Schicht emittierten Strahlung in die Konversionsschicht liegt. Dadurch kann die Konversionseffizienz über eine möglichst große Oberfläche optimiert werden.

Weitere Vorteile ergeben sich aus dem im Folgenden in Verbindung mit den Figuren 1 bis 6 beschriebenen Beispielen. Es zeigen:
Figuren 1A bis 1D jeweils einen schematischen Querschnitt eines Halbleiterchips in einem illustrativen Beispiel eines Verfahrens, das die vorliegende Erfindung als solche nicht definiert,
Figuren 2A bis 2C jeweils einen schematischen Querschnitt eines weiteren illustrativen Beispiels eines Halbleiterchips in einem Verfahren, das die vorliegende Erfindung als solche nicht definiert,
Figuren 3A bis 3D jeweils einen schematischen Querschnitt eines Ausführungsbeispiels eines Halbleiterchips im erfindungsgemäßen Herstellungsverfahren,
Figuren 4A, 5A jeweils einen schematischen Querschnitt eines weiteren illustrativen Beispiels eines Halbleiterchips, der die vorliegende Erfindung als solche nicht definiert,
Figuren 4B, 5B, 6A bis 6C jeweils eine schematische Aufsicht auf ein illustratives Beispiel eines Halbleiterchips, der die vorliegende Erfindung als solche nicht definiert,
Figur 7A einen schematischen Querschnitt eines Halbleiterchip nach dem Stand der Technik, und Figuren 7B, 8A bis 8E jeweils einen schematischen Querschnitt eines weiteren illustrativen

Beispiels eines Halbleiterchips, der die vorliegende Erfindung als solche nicht definiert.

In den Figuren können gleiche oder gleich wirkende Bestandteile jeweils mit den gleichen Bezugszeichen versehen sein. Die dargestellten Bestandteile und deren Größenverhältnisse untereinander sind grundsätzlich nicht als maßstabsgerecht anzusehen. Vielmehr können einzelne Bestandteile, wie zum Beispiel Schichten, Strukturen, Komponenten und Bereiche, zur besseren Darstellbarkeit und/oder zum besseren Verständnis übertrieben dick oder groß dimensioniert dargestellt sein.

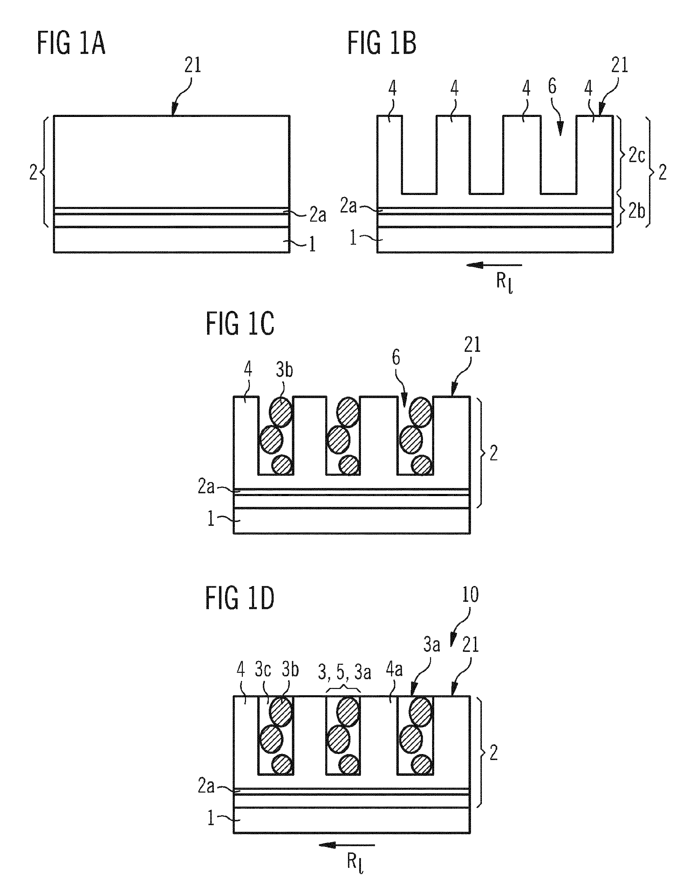

In den Figuren 1A bis 1D sind illustrative Halbleiterchips 10 dargestellt, die sich in verschiedenen Stadien im Herstellungsverfahren befinden.

In Figur 1A ist ein Halbleiterschichtenstapel 2 dargestellt, der auf ein Aufwachssubstrat 1 aufgewachsen worden ist. Auf dem Aufwachssubstrat 1 ist der Halbleiterschichtenstapel 2 angeordnet. Der Halbleiterschichtenstapel 2 weist eine Strahlungsaustrittsseite 21 auf, die dem Aufwachsubstrat 1 gegenüberliegend angeordnet ist. Zudem weist der Halbleiterschichtenstapel 2 eine aktive Schicht 2a auf, die geeignet ist, im Betrieb des Halbleiterchips elektromagnetische Strahlung zu erzeugen. Die in der aktiven Schicht 2a erzeugte elektromagnetische Strahlung tritt vorzugsweise zum größten Teil über die Strahlungsaustrittsseite 21 aus dem Halbleiterchip aus.

Die Schichten des Halbleiterschichtenstapels, die zwischen aktiver Schicht 2a und Aufwachsubstrat 1 angeordnet sind, sind vorzugsweise p-dotiert. Beispielsweise umfassen diese Schichten p-GaN. Die Schichten des Halbleiterschichtenstapels 2, die auf der von dem Aufwachsubstrat 1 gegenüberliegenden Seite der aktiven Schicht 2a angeordnet sind, sind vorzugsweise n-dotiert, beispielsweise n-GaN.

Im nächsten Verfahrensschritt, wie in Figur 1B dargestellt, wird der Halbleiterschichtenstapel von der n-Seite strukturiert. Insbesondere werden Vertiefungen 6 in dem Halbleiterschichtenstapel von der Strahlungsaustrittsseite 21 in Richtung aktiver Schicht 2a ausgebildet. So entsteht eine erste Nanostrukturierung 4, die eine Mehrzahl von Nanostäben umfasst. Die Nanostäbe 4 sind voneinander durch die Vertiefungen 6 getrennt. Vorzugsweise weisen die Nanostäbe 4 im Wesentlichen eine identische Höhe auf.

Die Vertiefungen 6 in der n-Seite des Halbleiterschichtenstapels 2 erstrecken sich bevorzugt nicht durch die aktive Schicht 2a hindurch. Der Halbleiterschichtenstapel 2 setzt sich somit aus zwei Bereichen 2b, 2c zusammen. Der erste Bereich 2b umfasst ganzflächig angeordnete Halbleiterschichten, die die aktive Schicht 2a umfassen, wobei diese ganzflächig ausgebildet ist.

Der zweite Bereich 2c umfasst eine Mehrzahl von Halbleiterschichten, die eine Nanostrukturierung aufweisen, also strukturiert ausgebildet sind. Im zweiten Bereich 2c ist also eine Schichtenfolge ausgebildet, die die Nanostäbe 4 und Vertiefungen 6 umfasst, wobei jeweils eine Vertiefung an einen Nanostab 4 angrenzt, sodass sich Nanostäbe 4 und Vertiefungen 6 abwechseln. Die Schichtenfolge ist dabei in lateraler Richtung Rₗ angeordnet. In lateraler Richtung Rₗ bedeutet insbesondere entlang der Ausdehnung des Aufwachsubstrats und somit auch entlang der Ausdehnungen der Halbleiterschichten des Halbleiterschichtenstapels. Die Schichtenfolge ist somit senkrecht zur Hauptabstrahlrichtung angeordnet beziehungsweise senkrecht zur Aufwachsrichtung der Schichten des Halbleiterschichtenstapels auf das Aufwachssubstrat.

Die Nanostäbe 4 der ersten Nanostrukturierung sind dabei in ihrer Größe derart angepasst, dass diese im Bereich oder größer der Wellenlänge der von der aktiven Schicht emittierten Strahlung liegt. Die Vertiefungen 6 weisen ebenfalls diese Größenordnung auf. Beispielsweise sind die Nanostäbe runde oder eckige GaN-Säulen mit Durchmessern im Bereich von 10 nm bis 200 nm. Die Vertiefungen weisen dabei Durchmesser von einigen 10 nm bis 200 nm auf. Die Höhe der Strukturen, also der Nanostäbe und der Vertiefungen, liegt im Bereich einiger 100 nm bis einige µm.

Die erste Nanostrukturierung kann beispielsweise dadurch hergestellt werden, dass die Halbleiterschichten des Halbleiterschichtenstapels im Bereich 2d ganzflächig aufgewachsen werden und anschließend strukturiert werden, beispielsweise mittels eines Laserstrukturierungsverfahrens. So können die Vertiefungen 6 in den ursprünglich ganzflächig ausgebildeten Halbleiterschichten hergestellt werden.

Alternativ kann das Herstellen der ersten Nanostrukturierung umfassen, dass zuerst die Schichten im ersten Bereich 2b ganzflächig auf das Aufwachssubstrat aufgewachsen werden und anschließend direkt strukturierte Schichten im Bereich 2c aufgewachsen werden. Ein strukturiertes Aufwachsen kann beispielsweise mittels einer Maskenschicht realisiert werden. Zur elektrischen Kontaktierung wird eine n-Kontaktierung großflächig auf der n-Seite des Halbleiterschichtenstapels angeordnet (nicht dargestellt). Die p-Kontaktierung kann dabei mittels einer geeigneten Überformung der Nanostäbe zum Beispiel mittels so genannte core/shell-Schichten erfolgen, die dem Fachmann bekannt sind und daher an dieser Stelle nicht näher erläutert werden. Aufgrund dieser core/shell-Schichten steht auch bei der p-Kontaktierung eine große Fläche zur Verfügung. Eine hinsichtlich der Stromaufweitung optimale Struktur ergibt sich insbesondere beim Vertauschen der n- und p-Dotierung des Halbleiterschichtenstapels.

Wie in Figur 1C dargestellt, werden nachfolgend in die Vertiefungen 6 Konversionselemente 3b eingebracht. Die Konversionselemente sind beispielsweise Konversionspartikel, die geeignet sind, zumindest einen Teil der von der aktiven Schicht 2a emittierte Strahlung in Strahlung einer anderen Wellenlänge umzuwandeln. Die Konversionselemente 3b werden dabei separat eingebracht. Das bedeutet, dass die Konversionselemente 3b nicht mit einem Matrixmaterial umgeben sind beziehungsweise in diesem eingebettet sind. Da die Vertiefungen 6 im vorliegenden Beispiel nicht bis zur aktiven Schicht 2a reichen, sind die Konversionselemente 3b in der Vertiefung 6 demnach nicht bis an die aktive Schicht 2a heran angeordnet. Zwischen Konversionselemente 3b und aktiver Schicht 2a ist somit Material des Halbleiterschichtenstapels 2 angeordnet.

Im nachfolgenden Herstellungsschritt, wie in Figur 1D dargestellt, wird anschließend ein Matrixmaterial 3c in die Vertiefungen eingebracht. Das Matrixmaterial 3c ist vorzugsweise hochbrechend, beispielsweise Al₂O₃, TiO₂. Bevorzugt umfasst das Matrixmaterial 3c ein strahlungs- und temperaturstabiles transparentes Material mit einem Brechungsindex von > 1,5.

Das Matrixmaterial 3c wird dabei derart in die Vertiefungen 6 des Halbleiterschichtenstapels 2 eingebracht, dass das Matrixmaterial diese Vertiefungen 6 vollständig ausfüllt.

Damit schließt das Matrixmaterial 3c die Strahlungsaustrittsfläche 21 des Halbleiterschichtenstapels 2 eben ab, insbesondere kann so eine ebene Fläche der Strahlungsaustrittsseite erzeugt werden. Das Matrixmaterial 3c ist insbesondere nicht auf der Strahlungsaustrittsseite 21 des Halbleiterschichtenstapels 2 angeordnet.

Das Konversionselement 3b und das Matrixmaterial 3c bilden zusammen die Konversionsschicht 3 aus. Im Bereich der ersten Nanostrukturierung 4 des Halbleiterschichtenstapels 2 sind somit Bereiche angeordnet, die die Konversionsschicht 3 umfassen und Bereiche, die lediglich Material des Halbleiterschichtenstapels umfassen, in diesem Fall also die Nanostäbe 4.

Aufgrund des Einbringens der Konversionsschicht 3 in lediglich den Vertiefungen 6 der ersten Nanostrukturierung 4 des Halbleiterschichtenstapels 2 wird eine Konversionsschicht 3 erzeugt, die als zweite Nanostrukturierung 5 ausgebildet ist. Die zweite Nanostrukturierung 5 umfasst dabei eine Mehrzahl von Nanostäben. Dabei greifen die erste Nanostrukturierung 4 und die zweite Nanostrukturierung 5 ineinander über. Insbesondere sind die erste Nanostrukturierung 4 und die zweite Nanostrukturierung 5 kammartig ausgebildet.

Im zweiten Bereich des Halbleiterschichtenstapels 2 wird somit eine vertikale Schichtenfolge mit direkt aneinandergrenzenden ersten Nanostrukturierungen 4 und zweiten Nanostrukturierungen 5 ausgebildet. Die Schichtenfolge weist insbesondere eine Mehrzahl von ersten Schichten 3a der ersten Nanostrukturierung und eine Mehrzahl von zweiten Schichten 4a der zweiten Nanostrukturierung auf, die in lateraler Richtung Rₗ ausgebildet sind.

Die erste Nanostrukturierung 4 und die zweite Nanostrukturierung 5 weisen jeweils vorzugsweise die gleiche Höhe auf, insbesondere in einem Bereich zwischen einschließlich 100 nm und einschließlich 1 µm.

Aufgrund der ersten Nanostrukturierung 4 wird eine möglichst große Berührungsfläche zwischen Konversionsschicht 3 und Halbleiterschichtenstapel 2 erzeugt. So kann eine möglichst große Wechselwirkungsfläche zwischen Konversionsschicht 3 und Halbleiterschichtenstapel 2 erzielt werden. Dadurch wird ermöglicht, dass die Konversionsschicht 3 und der Halbleiterschichtenstapel 2 optimal optisch und thermisch gekoppelt sind. Dies ermöglicht unter anderem auch eine verbesserte Steuerbarkeit des Konversionsgrades, da die Konversionsschicht 3 erst nach dem Herstellungsprozess des Halbleiterschichtenstapels 2 aufgebracht wird.

Der Brechungsindex der Konversionsschicht 3 ist dabei vorzugsweise an den Brechungsindex des Materials des Halbleiterschichtenstapels angepasst. Das bedeutet, dass die Brechungsindizes dieser Materialien möglichst ähnlich beziehungsweise gleich sind. Beispielsweise betragen die Brechungsindizes dieser zwei Materialien 2,4.

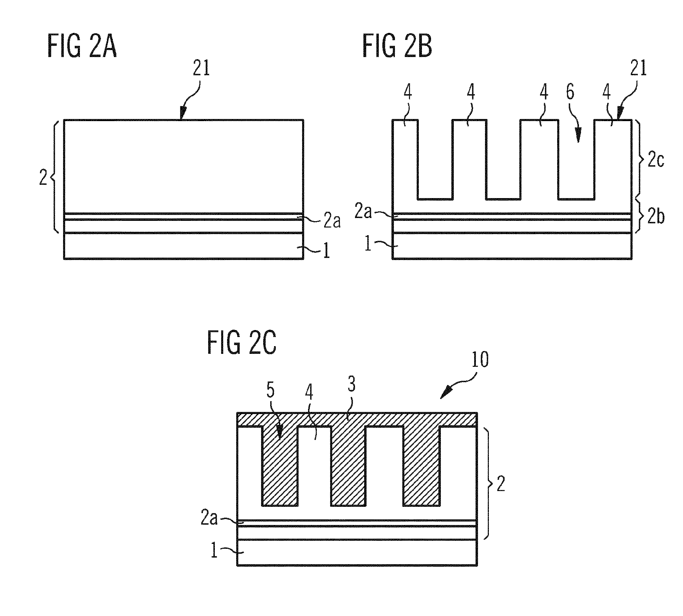

Im Beispiel der Figuren 2A bis 2C ist ein alternatives Herstellungsverfahren eines Halbleiterchips dargestellt, der die vorliegende Erfindung als solche nicht definiert. Die Figur 2A entspricht dabei im Wesentlichen der Figur 1A, die Figur 2B im Wesentlichen der Figur 1B.

Die Verfahrensschritte der Figuren 1C und 1D werden im Beispiel der Figur 2C dagegen gleichzeitig durchgeführt. Insbesondere wird die Konversionsschicht 3 in einem Verfahrensschritt in die erste Nanostrukturierung eingebracht. Das bedeutet, dass das Konversionselement und das Matrixmaterial der Konversionsschicht 3 bereits vor Aufbringen auf den Halbleiterschichtenstapel 2 vermengt ist und zusammen auf den Halbleiterschichtenstapel 2 aufgebracht werden. Ein derartiges Aufbringen kann beispielsweise mittels einer direkten Deposition der Konversionsschicht zum Beispiel über pulsed laser deposition (PLD) ermöglicht werden.

Die Konversionsschicht 3 ist im Beispiel der Figur 2C im Bereich der ersten Nanostrukturierung 4, insbesondere in den Vertiefungen des Halbleiterschichtenstapels 2 eingebracht. Zudem ist die Konversionsschicht zusätzlich auf der Strahlungsaustrittsseite 21 des Halbleiterschichtenstapels 2 angeordnet. Die Konversionsschicht kann somit in zwei Bereiche eingeteilt werden. Im ersten Bereich ist die Konversionsschicht als zweite Nanostrukturierung 5 ausgebildet und somit nur in den Zwischenräumen zwischen den Nanostäben 4 der ersten Nanostrukturierung angeordnet. Im zweiten Bereich ist die Konversionsschicht 3 ganzflächig auf den Halbleiterschichtenstapel 2 aufgebracht. In diesem Bereich ist die Konversionsschicht 3 somit auf den Nanostäben 4 des Halbleiterschichtenstapels 2 und den Nanostäben 5 der Konversionsschicht 3 vollflächig aufgebracht.

Im Übrigen stimmt das Beispiel der Figur 2C mit dem Beispiel der Figur 1D überein.

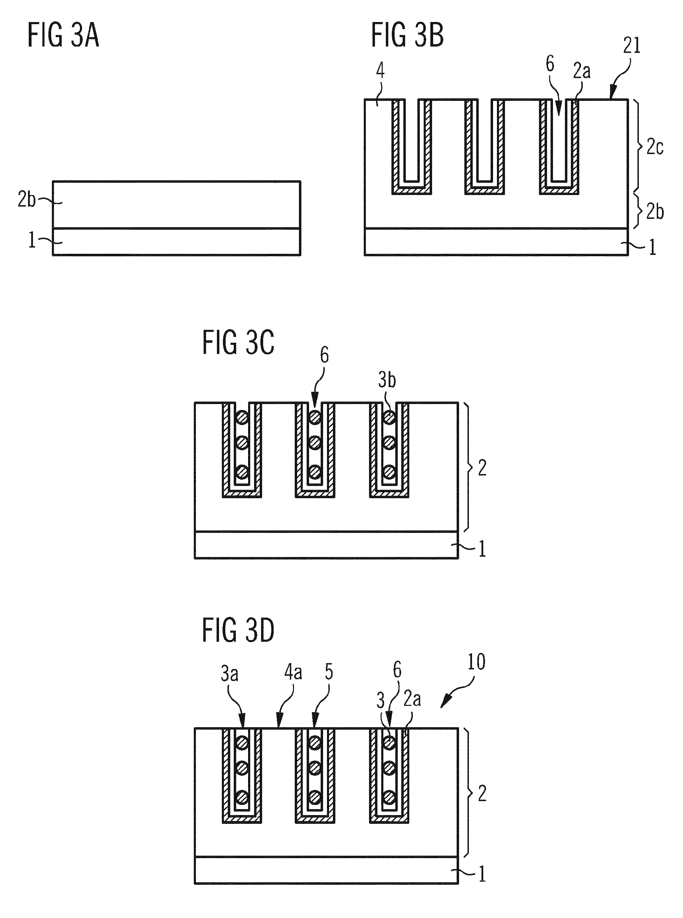

In den Figuren 3A bis 3D ist ein Ausführungsbeispiel zur Herstellung eines erfindungsgemäßen Halbleiterchips 10 gezeigt.

Wie in Figur 3A dargestellt, werden Schichten des Halbleiterschichtenstapels 2b ganzflächig auf ein Aufwachssubstrat 1 epitaktisch aufgewachsen. Diese Schichten bilden einen ersten Bereich 2b des Halbleiterschichtenstapels aus. Insbesondere weist dieser Bereich 2b nicht die aktive Schicht des Halbleiterschichtenstapels auf.

Anschließend wird, wie in Figur 3B dargestellt, ein zweiter Bereich 2c des Halbleiterschichtenstapels auf den ganzflächig aufgebrachten Bereich 2b aufgebracht und strukturiert. Nach dem Erzeugen der Nanostrukturierung, insbesondere dem Ausbilden der Vertiefungen 6, sodass Nanostäbe 4 entstehen, wird eine aktive Schicht 2a aufgewachsen, die beispielsweise InGaN Multiquantumwells (MQW) enthält, die alle Seitenflächen und die Bodenfläche der Vertiefungen 6 bedeckt. Auf diese aktive Schicht wird anschließend eine p-dotierte Schicht oder p-dotierte Schichten abgeschieden, sodass die aktive Schicht 2a vollständig mit dem Material dieser Schicht überdeckt ist.

Zur Verbesserung der Stromaufweitung in den p-Schichten des Halbleiterschichtenstapels kann anschließend optional ein transparentes Oxid wie beispielsweise ITO oder znO auf die Seitenflächen aufgebracht werden (nicht dargestellt).

Die aktive Schicht 2a befindet sich somit im zweiten Bereich 2c und ist nicht lediglich längs zum Aufwachssubstrat 1 angeordnet, sondern erstreckt sich auch in Hauptabstrahlrichtung entlang der Seitenflächen der Vertiefungen 6.

Anschließend wird, wie in Figur 3C dargestellt, in den Zwischenräumen der ersten Nanostrukturierung das Konversionselement 3b eingebracht. Dieser Verfahrensschritt entspricht im Wesentlichen dem Verfahrensschritt des Beispiels aus Figur 1C.

Anschließend wird, wie in Figur 3D dargestellt, das Matrixmaterial 3c in die Vertiefungen der ersten Nanostrukturierung eingebracht. Dieser Verfahrensschritt entspricht insbesondere im Wesentlichen dem Verfahrensschritt des Beispiels zu Figur 1D.

Zur elektrischen Kontaktierung des Halbleiterchips 10 kann die p-Kontaktierung und die n-Kontaktierung von oben, also von der Strahlungsaustrittsseite 21 erfolgen (nicht dargestellt).

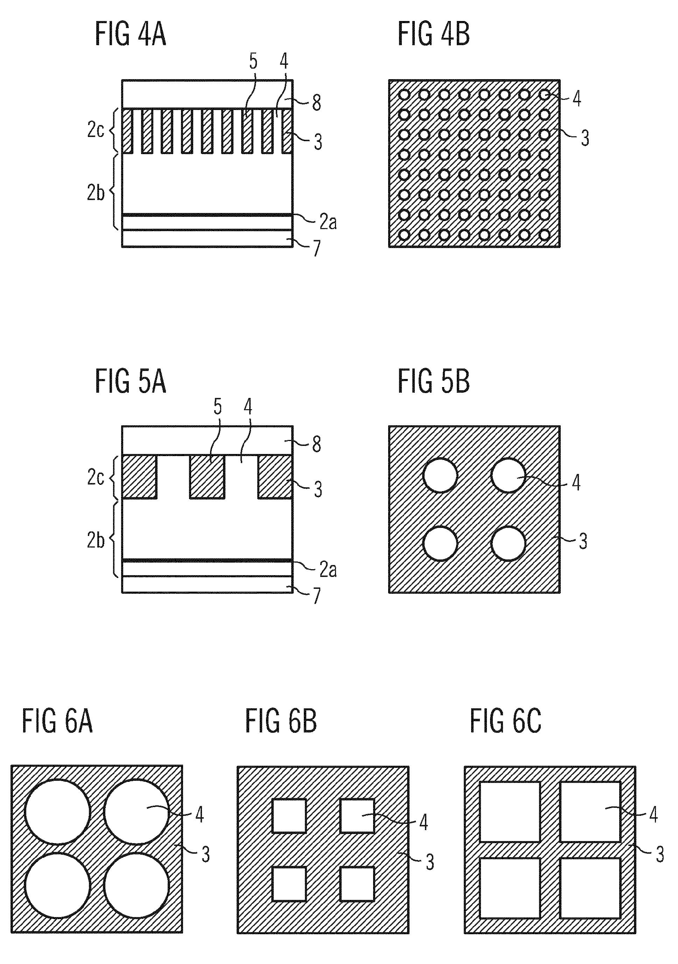

In Figur 4A ist ein Querschnitt eines Beispiels eines illustrativen Halbleiterchips dargestellt, der die vorliegende Erfindung als solche nicht definiert. Auf einer Spiegelschicht (7), die beispielsweise Silber enthält, ist der erste Bereich des Halbleiterschichtenstapels 2b und der zweite Bereich des Halbleiterschichtenstapels 2c angeordnet. Im zweiten Bereich 2c ist die erste Nanostrukturierung 4 ausgebildet. Die Zwischenräume der ersten Nanostrukturierung 4 sind mit Konversionsschicht 3 gefüllt. Der Strahlungsaustrittsseite des Halbleiterchips kann eine Abdeckschicht 8, beispielsweise eine Silikonschicht, nachgeordnet sein.

Im Übrigen stimmt das Beispiel der Figur 4A mit dem Beispiel der Figur 1D überein.

In Figur 4B ist eine Aufsicht auf einen derartig ausgestalteten Halbleiterchip dargestellt. Die Nanostäbe 4 der ersten Nanostrukturierung sind matrixartig angeordnet. Die Zwischenräume zwischen den Nanostäben 4 sind mit Konversionsschicht 3 gefüllt, sodass eine ebene Fläche ausgebildet wird. Die Nanostäbe 4 sind im vorliegenden Beispiel frei von Material der Konversionsschicht 3. Die optimale Größe der Nanostäbe 4 sind derart eingestellt, dass diese im Bereich oder größer der von der aktiven Schicht emittierten Strahlung liegt. Im Bereich der Eindringtiefe ist die erste Nanostrukturierung, insbesondere die Nanostäbe 4, mit der Konversionsschicht 3 durchsetzt. So kann eine optimale thermische und optische Kopplung der Konversionsschicht an den Halbleiterschichtenstapel erzielt werden. Zudem wird so eine verbesserte Steuerbarkeit des Konversionsgrads erzielt.

In Figur 5A ist entgegen dem Beispiel der Figur 4A die erste Nanostrukturierung 4 und die zweite Nanostrukturierung 5 unterschiedlich in ihrer Größenordnung ausgebildet. Die erste und zweite Nanostrukturierungen 4, 5 weisen insbesondere einen größeren Querschnitt als im Beispiel der Figur 4A auf.

Im Übrigen stimmt das Beispiel der Figur 5A mit dem Beispiel der Figur 4A überein.

In Figur 5B ist eine Aufsicht auf einen Halbleiterchip gemäß dem Beispiel der Figur 5A dargestellt. Die Nanostäbe 4 der ersten Nanostrukturierung weisen dabei einen größeren Abstand zueinander auf. Somit füllt die Konversionsschicht 3 einen größeren Raum zwischen den Nanostäben 4 auf. Insgesamt ist somit mehr Konversionsschichtenmaterial 3 auf dem Halbleiterschichtenstapel angeordnet.

Im Übrigen stimmt das Beispiel der Figur 5 mit dem Beispiel der Figur 4B überein.

In den Figuren 6A bis 6C sind weitere Beispiele jeweils einer Ausgestaltung des Halbleiterchips von der Oberseite her gezeigt. Im Beispiel der Figur 6A sind im Vergleich zu dem Beispiel der Figur 5B die Durchmesser der Nanostäbe 4 der ersten Nanostrukturierung größer ausgebildet. Damit verkleinert sich die Fläche des Halbleiterchips, auf dem die Konversionsschicht 3 angeordnet ist.

In dem Beispiel der Figur 6B sind im Vergleich zu dem Beispiel der Figur 5B die Nanostäbe 4 rechteckförmig und nicht rund ausgeführt. Die matrixartige Anordnung der Nanostäbe 4 bleibt erhalten.

Im Übrigen stimmt das Beispiel der Figur 6B mit dem Beispiel der Figur 5B überein.

In dem Beispiel der Figur 6C sind die Durchmesser der Nanostäbe 4 im Vergleich zu dem Beispiel der Figur 6B vergrößert. So wird ähnlich wie in dem Beispiel der Figur 6A die Fläche des Halbleiterschichtenstapels, auf dem die Konversionsschicht 3 angeordnet ist, verkleinert.

Je nach gewünschten Konversionsgrad kann die Größe der Nanostäbe 4 und damit bedingt die Fläche des mit Konversionsschichtmaterial 3 bedeckten Halbleiterschichtenstapels eingestellt werden.

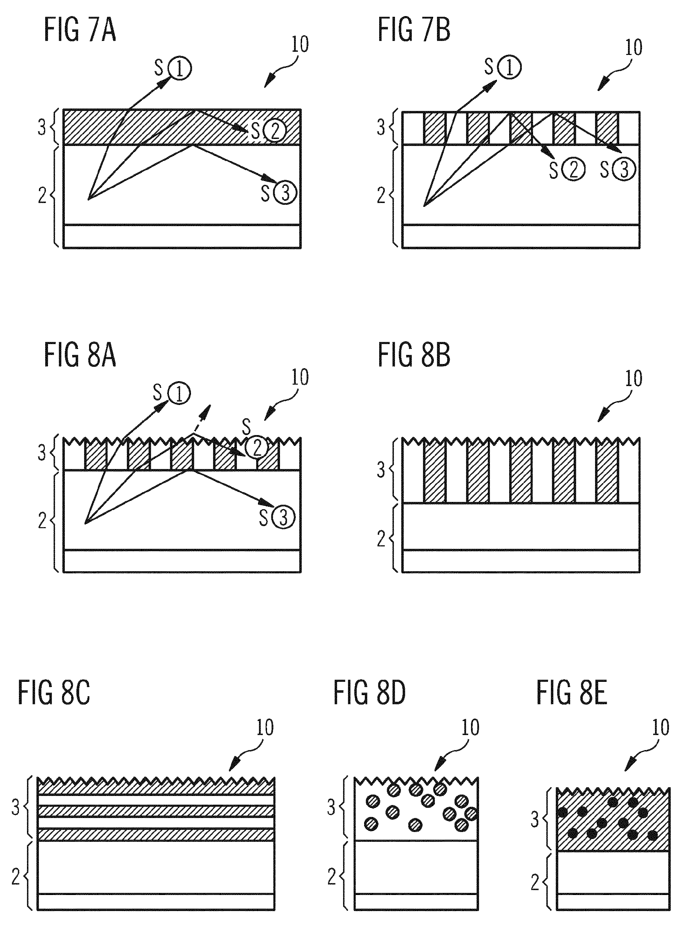

In Figur 7A ist ein Beispiel eines Halbleiterchips 10 umfassend eine aktive Schicht zur Strahlungserzeugung nach dem Stand der Technik dargestellt, bei dem auf einem Halbleiterschichtenstapel 2 eine Konversionsschicht 3 aufgebracht ist. Der Halbleiterschichtenstapel 2 und die Konversionsschicht 3 weisen dabei jeweils keine Nanostrukturierung auf, sind also eine planare Schichten ausgebildet.

In der Figur 7A sind mögliche Strahlengänge S1, S2, S3 der von der aktiven Schicht emittierten Strahlung als Pfeile dargestellt.

Bei einem derart ausgebildeten Halbleiterchip kann aufgrund von Totalreflexion an der Grenzfläche zwischen Halbleiterschichtenstapel und Konversionsschicht ein Großteil des Lichts nicht in die Konversionsschicht eindringen oder aus dem Halbleiterchip ausgekoppelt werden, wie mittels der Strahlengänge S2 und S3 gezeigt.

Ein derartiger Effekt kann auch bei einer strukturierten Konversionsschicht auftreten (nicht dargestellt), in dem Falle, dass die Strukturgröße im Bereich der von der aktiven Schicht emittierten Strahlungswellenlänge oder kleiner liegt, da die Strukturierung von der optischen Welle so nicht aufgelöst werden kann und die strukturierte Schicht daher wie eine Schicht mittleren Brechungsindizes, dem Fachmann auch bekannt unter dem Begriff Metamaterial, erscheint.

In Figur 7B ist ein Beispiel eines Halbleiterchips 10 umfassend eine aktive Schicht zur Strahlungserzeugung gemäß den Prinzipien der Erfindung dargestellt. In Figur 7B sind ebenfalls mögliche Strahlengänge S1, S2, S3 der von der aktiven Schicht emittierten Strahlung mittels Pfeile dargestellt. Der Halbleiterchip 10 weist einen Halbleiterschichtenstapel 2 auf, der beispielsweise gemäß dem Beispiel der Figur 2D ausgebildet ist. Auf dem Halbleiterschichtenstapel ist eine Konversionsschicht 3 angeordnet, die als Strukturierung eine laterale Schichtabfolge aufweist. Insbesondere wechseln sich Bereiche der Konversionsschicht umfassend ein hochbrechendes Material wie beispielsweise TiO₂, die frei sind von Konversionspartikel, und Bereiche der Konversionsschicht umfassend Konversionspartikel, die nicht zwangsläufig ein hochbrechendes Material umfassen, in lateraler Richtung ab.

Wie anhand der Strahlengänge S1, S2, S3 dargestellt kann ein größerer Anteil der von der aktiven Schicht emittierten Strahlung in die Konversionsschicht eindringen. Insbesondere kann mittels einer bereichsweisen Verwendung eines Materials der Konversionsschicht mit höherem Brechungsindex der mittlere Brechungsindex der Konversionsschicht der Konversionsschicht so eingestellt werden, dass dieser etwa dem des Halbleitermaterials entspricht, sodass Strahlung weitestgehend ungehindert in die Konversionsschicht eindringen kann.

Das Beispiel der Figur 8A unterschiedet sich von dem Beispiel der Figur 1D dadurch, dass die von dem Halbleiterschichtenstapel abgewandte Seite der Konversionsschicht eine weitere Strukturierung, insbesondere eine Aufrauung aufweist. Dadurch kann der Anteil der Strahlung, der an der Grenzfläche Konversionsschicht und Umgebung totalreflektiert wird, reduziert werden, sodass sich mit Vorteil die Strahlungsauskoppeleffizienz weiter erhöht. Dies wird insbesondere durch die in Figur 8A gezeigten Strahlengänge S1, S2, S3 verdeutlicht.

Das Beispiel der Figur 8B unterschiedet sich von dem Beispiel der Figur 7B dadurch, dass die von dem Halbleiterschichtenstapel abgewandte Seite der Konversionsschicht eine weitere Strukturierung, insbesondere eine Aufrauung aufweist. Dadurch kann der Anteil der Strahlung, der an der Grenzfläche Konversionsschicht und Umgebung totalreflektiert wird, weiter reduziert werden, sodass sich mit Vorteil die Strahlungsauskoppeleffizienz weiter erhöht.

Das Beispiel der Figur 8C unterscheidet sich von dem Beispiel der Figur 8B dadurch, dass die Konversionsschicht anstelle einer lateralen Schichtabfolge eine vertikale Schichtabfolge umfasst. Insbesondere sind Schichten aufweisend ein hochbrechendes Material und Schichten aufweisend Konversionspartikel abwechselnd übereinander angeordnet beziehungsweise gestapelt.

Das Beispiel der Figur 8D unterscheidet sich von dem Beispiel der Figur 7B dadurch, dass die Konversionsschicht 3 als Strukturierung eingebettete Konversionspartikel in einem hochbrechenden Material aufweist. Die Konversionsschicht 3 des Beispiels der Figur 8E weist als Strukturierung hochbrechende Konversionspartikel eingebettet in einem nicht zwangsläufig hochbrechenden Material auf.

Die Erfindung ist durch die Patentansprüche definiert Diese Patentanmeldung beansprucht die Priorität der deutschen Patentanmeldung 10 2010 051 286. 9.

## Patentansprüche

1. Optoelektronischer Halbleiterchip (10) mit
- einem Halbleiterschichtenstapel (2), der eine zur Strahlungserzeugung vorgesehene aktive Schicht (2a) und eine Strahlungsaustrittsseite (21) aufweist, und
- einer Konversionsschicht (3), die auf der Strahlungsaustrittsseite (21) des Halbleiterschichtenstapels (2) angeordnet ist, wobei
- die Konversionsschicht (3) geeignet ist, zumindest einen Teil der von der aktiven Schicht (2a) emittierten Strahlung in Strahlung einer anderen Wellenlänge umzuwandeln,
- die Strahlungsaustrittsseite (21) des Halbleiterschichtenstapels (2) eine erste Nanostrukturierung (4) aufweist, und
- die Konversionsschicht (3) in der ersten Nanostrukturierung (4) angeordnet ist, **dadurch gekennzeichnet, dass**:
- sich die erste Nanostrukturierung (4) aus einer Mehrzahl von Nanostäben und Vertiefungen (6) zusammensetzt, und
- die aktive Schicht (2a) jeweils nur entlang von Seitenflächen und Grundfläche der ersten Nanostrukturierung (4) angeordnet ist, sodass die aktive Schicht (2a) durch separate, einzelne Bereiche und nicht durch eine zusammenhängende Schicht gebildet ist.

2. Halbleiterchip nach Anspruch 1, wobei
die aktive Schicht (2a) jeweils nur entlang der Seitenflächen und der Grundflächen der Vertiefungen (6) ausgebildet ist und diese jeweils einstückig umgibt, sodass die aktive Schicht (2a) durch einzelne Bereiche gebildet ist, die die Form einer Mantelfläche eines halben Zylinders oder eines halben Kegelstumpfes aufweisen, halbiert senkrecht zu einer Längsachse des Zylinders oder des Kegelstumpfes.

3. Halbleiterchip nach einem der vorhergehenden Ansprüche, wobei
auf die aktive Schicht (2a) eine p-dotierte Schicht oder p-dotierte Schichten abgeschieden sind, sodass die aktive Schicht (2a) vollständig mit einem Material dieser mindestens einen p-dotierten Schicht überdeckt ist, und wobei zur Verbesserung einer Stromaufweitung ein transparentes Oxid, das ITO oder ZnO ist, auf die Seitenflächen aufgebracht ist.

4. Halbleiterchip nach einem der vorhergehenden Ansprüche, wobei
die Konversionsschicht (3) die erste Nanostrukturierung (4) derart vollständig ausfüllt, dass eine ebene Fläche ausgebildet ist.

5. Halbleiterchip nach einem der vorhergehenden Ansprüche, wobei
die Konversionsschicht als zweite Nanostrukturierung (5) ausgebildet ist, die eine Mehrzahl von Nanostäben umfasst.

6. Halbleiterchip nach Anspruch 5, wobei
die erste Nanostrukturierung (4) und die zweite Nanostrukturierung (5) derart zueinander angeordnet sind, dass diese ineinander greifen, und
wobei die erste Nanostrukturierung (4) und die zweite Nanostrukturierung (5) kammartig ausgebildet sind.

7. Halbleiterchip nach einem der vorhergehenden Ansprüche 5 oder 6, wobei
die erste Nanostrukturierung (4) und die zweite Nanostrukturierung (5) direkt aneinander angrenzen, sodass diese eine Schichtenfolge aufweisend eine Mehrzahl von ersten Schichten (3a) und eine Mehrzahl von zweiten Schichten (4a) in lateraler Richtung (Rₗ) ausbilden.

8. Halbleiterchip nach einem der vorhergehenden Ansprüche, wobei
die Konversionsschicht (3) zusätzlich auf der ersten Nanostrukturierung (4) angeordnet ist.

9. Halbleiterchip nach einem der vorhergehenden Ansprüche, wobei
die erste Nanostrukturierung (4) und/oder die zweite Nanostrukturierung (5) jeweils eine Höhe in einem Bereich zwischen einschließlich 100 nm und einschließlich 1 µm aufweisen.

10. Halbleiterchip nach einem der vorhergehenden Ansprüche, wobei
- die aktive Schicht (2a) InGaN Multiquantumwells enthält,
- ein Matrixmaterial (3c) in die Vertiefungen (6) eingebracht ist,
- das Matrixmaterial (3c) Al₂O₃ oder TiO₂ ist,
- das Matrixmaterial (3c) die Vertiefungen (6) vollständig ausfüllt, und
- das Matrixmaterial (3c) die Strahlungsaustrittsseite (21) des Halbleiterschichtenstapels (2) eben abschließt, sodass das Matrixmaterial (3c) nicht auf der Strahlungsaustrittsseite (21) des Halbleiterschichtenstapels (2) angeordnet ist.

11. Halbleiterchip nach einem der vorhergehenden Ansprüche, wobei
die Konversionsschicht (3) und der Halbleiterschichtenstapel (2) optisch und thermisch gekoppelt sind.

12. Halbleiterchip nach einem der vorhergehenden Ansprüche, wobei
der Halbleiterchip (10) ein Dünnfilm-Chip ist, bei dem ein Aufwachssubstrat (1), auf dem der Halbleiterschichtenstapel (2) epitaktisch aufgewachsen wurde, vollständig abgelöst ist.

13. Verfahren zum Herstellen eines Halbleiterchips (10) nach einem der vorhergehenden Ansprüche mit folgenden Verfahrensschritten:
- Bereitstellen eines Aufwachssubstrats (1),
- Aufwachsen eines Halbleiterschichtenstapels (2) auf das Aufwachssubstrat (1), der eine aktive Schicht (2a) und eine Strahlungsaustrittsseite (21) umfasst,
- Ausbilden einer ersten Nanostrukturierung (4) an der Strahlungsaustrittsseite (21), und
- Einbringen einer Konversionsschicht (3) in die erste Nanostrukturierung (4).

14. Verfahren nach Anspruch 13, wobei
das Aufwachsen des Halbleiterschichtenstapels (2) und das Ausbilden der ersten Nanostrukturierung (4) die folgenden Schritte umfasst:
- Aufwachsen von ersten Schichten (2b) des Halbleiterschichtenstapels (2) ganzflächig auf das Aufwachssubstrat (1), und
- Aufwachsen von strukturierten zweiten Schichten (2c) des Halbleiterschichtenstapels (2) mittels einer Maskenschicht.

15. Verfahren nach Anspruch 13 oder 14, wobei das Aufbringen der Konversionsschicht (3) umfasst:
- Einbringen eines Konversionselements (3b) in die erste Nanostrukturierung (4) und anschließendes Hinzufügen eines Matrixmaterials (3c) in die erste Nanostrukturierung (4), oder
- Aufbringen der Konversionsschicht (3) mittels eines Laserstrahlverdampfens.

## Claims

1. Optoelectronic semiconductor chip (10) comprising
- a semiconductor layer stack (2), which has an active layer (2a) provided for generating radiation and a radiation exit side (21), and
- a conversion layer (3), which is arranged on the radiation exit side (21) of the semiconductor layer stack (2), wherein
- the conversion layer (3) is suitable for converting at least part of the radiation emitted by the active layer (2a) into radiation of a different wavelength,
- the radiation exit side (21) of the semiconductor layer stack (2) has a first nanostructuring (4), and
- the conversion layer (3) is arranged in the first nanostructuring (4), **characterized in that**:
- the first nanostructuring (4) is composed of a plurality of nanorods and recesses (6), and
- the active layer (2a) is arranged in each case only along side surfaces and the base surface of the first nanostructuring (4), such that the active layer (2a) is formed by separate, individual regions and not by a coherent layer.

2. Semiconductor chip according to Claim 1, wherein the active layer (2a) is formed in each case only along the side surfaces and the base surfaces of the recesses (6) and surrounds the latter in each case in one piece, such that the active layer (2a) is formed by individual regions which are in the form of a peripheral surface of a half cylinder or of a half truncated cone, bisected perpendicular to a longitudinal axis of the cylinder or of the truncated cone.

3. Semiconductor chip according to either of the preceding claims, wherein
a p-doped layer or p-doped layers is/are deposited on the active layer (2a), such that the active layer (2a) is covered completely with a material of said at least one p-doped layer, and
wherein a transparent oxide, which is ITO or ZnO, is applied to the side surfaces to improve current spreading.

4. Semiconductor chip according to one of the preceding claims, wherein
the conversion layer (3) fills the first nanostructuring (4) completely in such a manner that a planar surface is formed.

5. Semiconductor chip according to one of the preceding claims, wherein
the conversion layer is formed as a second nanostructuring (5) which comprises a plurality of nanorods.

6. Semiconductor chip according to Claim 5, wherein
the first nanostructuring (4) and the second nanostructuring (5) are arranged in relation to one another in such a manner that they engage into one another, and
wherein the first nanostructuring (4) and the second nanostructuring (5) have a comb-like form.

7. Semiconductor chip according to either of the preceding Claims 5 and 6, wherein
the first nanostructuring (4) and the second nanostructuring (5) directly adjoin one another, such that they form a layer sequence having a plurality of first layers (3a) and a plurality of second layers (4a) in a lateral direction (Rₗ).

8. Semiconductor chip according to one of the preceding claims, wherein
the conversion layer (3) is additionally arranged on the first nanostructuring (4).

9. Semiconductor chip according to one of the preceding claims, wherein
the first nanostructuring (4) and/or the second nanostructuring (5) each have a height in a range of between 100 nm and 1 µm, inclusive.

10. Semiconductor chip according to one of the preceding claims, wherein
- the active layer (2a) contains InGaN multi quantum wells,
- a matrix material (3c) is introduced into the recesses (6),
- the matrix material (3c) is Al₂O₃ or TiO₂,
- the matrix material (3c) fills the recesses (6) completely, and
- the matrix material (3c) terminates the radiation exit side (21) of the semiconductor layer stack (2) in a planar manner, such that the matrix material (3c) is not arranged on the radiation exit side (21) of the semiconductor layer stack (2).

11. Semiconductor chip according to one of the preceding claims, wherein
the conversion layer (3) and the semiconductor layer stack (2) are optically and thermally coupled.

12. Semiconductor chip according to one of the preceding claims, wherein
the semiconductor chip (10) is a thin-film chip, in which a growth substrate (1), on which the semiconductor layer stack (2) has been grown epitaxially, is completely detached.

13. Method for producing a semiconductor chip (10) according to one of the preceding claims, said method comprising the following method steps:
- providing a growth substrate (1),
- growing a semiconductor layer stack (2) onto the growth substrate (1), which comprises an active layer (2a) and a radiation exit side (21),
- forming a first nanostructuring (4) on the radiation exit side (21), and
- introducing a conversion layer (3) into the first nanostructuring (4).

14. Method according to Claim 13, wherein
the growth of the semiconductor layer stack (2) and the formation of the first nanostructuring (4) comprise the following steps:
- growing first layers (2b) of the semiconductor layer stack (2) onto the whole surface of the growth substrate (1), and
- growing structured second layers (2c) of the semiconductor layer stack (2) by means of a mask layer.

15. Method according to Claim 13 or 14, wherein the application of the conversion layer (3) comprises:
- introducing a conversion element (3b) into the first nanostructuring (4) and subsequently adding a matrix material (3c) into the first nanostructuring (4), or
- applying the conversion layer (3) by means of laser beam evaporation.

## Revendications

1. Puce semi conductrice optoélectronique (10) comportant :
- une pile de couches semi-conductrices (2), qui présente une couche active (2a) prévue pour la génération d'un rayonnement et un côté de sortie de rayonnement (21), et
- une couche de conversion (3), qui est disposée sur le côté de sortie de rayonnement (21) de la pile de couches semi-conductrices (2), dans laquelle
- la couche de conversion (3) est adaptée pour convertir au moins une partie du rayonnement émis par la couche active (2a) en un rayonnement d'une autre longueur d'onde,
- le côté de sortie de rayonnement (21) de la pile de couches semi-conductrices (2) présente une première nano-structuration (4), et
- la couche de conversion (3) est disposée dans la première nano-structuration (4), **caractérisée en ce que**
- la première nano-structuration (4) est composée d'une pluralité de nano-barres et de cavités (6), et
- la couche active (2a) est disposée respectivement seulement le long des surfaces latérales et de la surface de base de la première nano-structuration (4), de sorte que la couche active (2a) soit formée par des zones séparées individuelles et pas par une couche cohérente.

2. Puce semi-conductrice selon la revendication 1, dans laquelle la couche active (2a) est réalisée à chaque fois seulement le long des surfaces latérales et des surfaces de base des cavités (6) et entoure respectivement ces dernières en un seul tenant, de sorte que la couche active (2a) soit formée par des zones individuelles, qui présentent la forme d'une surface de gaine d'un demi-cylindre ou d'un demi-cône tronqué, divisé en moitié perpendiculairement à un axe longitudinal du cylindre ou du cône tronqué.

3. Puce semi-conductrice selon une des revendications précédentes, dans laquelle sur la couche active (2a) une couche p-dopée ou des couches p-dopées sont déposées, de sorte que la couche active (2a) soit recouverte totalement par un matériau de cette au moins une couche p-dopée, et dans laquelle afin d'améliorer une propagation de courant, un oxyde transparent, qui est ITO ou ZnO, est appliqué sur les surfaces latérales.

4. Puce semi-conductrice selon une des revendications précédentes, dans laquelle la couche de conversion (3) remplit totalement la première nano-structuration (4), de sorte qu'une surface plane soit réalisée.

5. Puce semi-conductrice selon une des revendications précédentes, dans laquelle la couche de conversion est réalisée en tant que deuxième nano-structuration (5), qui comprend une pluralité de nano-barres.

6. Puce semi-conductrice selon la revendication 5, dans laquelle la première nano-structuration (4) et la deuxième nano-structuration (5) sont disposées l'une par rapport à l'autre de telle sorte qu'elles viennent en prise l'une dans l'autre et dans laquelle la première nano-structuration (4) et la deuxième nano-structuration (5) sont réalisées en forme de peigne.

7. Puce semi-conductrice selon une des revendications précédentes 5 ou 6, dans laquelle la première nano-structuration (4) et la deuxième nano-structuration (5) sont directement adjacentes l'une par rapport à l'autre, de sorte que celles-ci forment une succession de couches présentant une pluralité de premières couches (3a) et une pluralité de deuxièmes couches (4a) dans la direction latérale (R₁).

8. Puce semi-conductrice selon une des revendications précédentes, dans laquelle la couche de conversion (3) est disposée en outre sur la première nano-structuration (4).

9. Puce semi-conductrice selon une des revendications précédentes, dans laquelle la première nano-structuration (4) et/ou la deuxième nano-structuration (5) présentent respectivement une hauteur dans une plage comprise entre 100 nm inclus et 1 µm inclus.

10. Puce semi-conductrice selon une des revendications précédentes, dans laquelle
- la couche active (2a) contient un puits multi quantique InGaN,
- un matériau de matrice (3c) est placé dans les cavités (6),
- le matériau de matrice (3c) est Al₂O₃ ou TiO₂,
- le matériau de matrice (3c) remplit totalement les cavités (6), et
- le matériau de matrice (3c) isole également le côté de sortie de rayonnement (21) de la pile de couches semi-conductrices (2), de sorte que le matériau de matrice (3c) ne soit pas disposé sur le côté de sortie de rayonnement (21) de la pile de couches semi-conductrices (2).

11. Puce semi-conductrice selon une des revendications précédentes, dans laquelle
la couche de conversion (3) et la pile de couches semi-conductrices (2) sont couplées optiquement et thermiquement.

12. Puce semi-conductrice selon une des revendications précédentes, dans laquelle la puce semi-conductrice (10) est une puce à film mince, dans laquelle un substrat de croissance (1), sur lequel la pile de couches semi-conductrices (2) a cru de manière épitaxiale, a été totalement dissous.

13. Procédé de fabrication d'une puce semi-conductrice (10) selon une des revendications précédentes avec les étapes de procédé suivantes :
- fourniture d'un substrat de croissance (1),
- croissance d'une pile de couches semi-conductrices (2) sur le substrat de croissance (1), qui comprend une couche active (2a) et un côté de sortie de rayonnement (21),
- réalisation d'une première nano-structuration (4) sur le côté de sortie de rayonnement (21), et
- placement d'une couche de conversion (3) dans la première nano-structuration (4).

14. Procédé selon la revendication 13, dans lequel la croissance de la pile de couches semi-conductrices (2) et la réalisation de la première nano-structuration (4) comprennent les étapes suivantes :
- croissance de premières couches (2b) de la pile de couches semi-conductrices (2) sur la totalité de la surface sur le substrat de croissance (1), et
- croissance de deuxièmes couches structurées (2c) de la pile de couches semi-conductrices (2) au moyen d'une couche de masque.

15. Procédé selon la revendication 13 ou 14, dans lequel l'application de la couche de conversion (3) comprend de :
- introduire un élément de conversion (3b) dans la première nano-structuration (4) et ensuite ajouter un matériau de matrice (3c) dans la première nano-structuration (4), ou
- appliquer la couche de conversion (3) au moyen d_{'}une évaporation par rayon laser.
